# EUROPÄISCHE PATENTSCHRIFT

(11) **EP 2 601 559 B1**
(45) Veröffentlichungstag und Bekanntmachung des Hinweises auf die Patenterteilung: **20.01.2016**
(21) Anmeldenummer: 11738431.3
(22) Anmeldetag: 22.07.2011
(51) Int. Cl.: G05B 19/042

(54) **DREISTUFIGE SPEICHERANORDNUNG**
THREE-STAGE MEMORY ARRANGEMENT
SYSTÈME DE MÉMOIRE À TROIS ÉTAGES

(30) Priorität: 03.08.2010 DE 102010038850
(43) Veröffentlichungstag der Anmeldung: 12.06.2013
(73) Patentinhaber: Continental Teves AG & Co. oHG, 60488 Frankfurt (DE)
(72) Erfinder: SCHRIEFER, Jörn, 64347 Griesheim (DE); SCHERSCHMIDT, Jürgen, 60322 Frankfurt (DE); PEICHL, Thomas, 61206 Wöllstadt (DE)
(86) Internationale Anmeldenummer: PCT/EP2011/062680
(87) Internationale Veröffentlichungsnummer: WO 2012/016866

(56) Entgegenhaltungen:
- DE-A1- 19 529 718

## Beschreibung

Die Erfindung betrifft eine Speicheranordnung gemäß Oberbegriff von Anspruch 1 sowie die Verwendung der Speicheranordnung in Kraftfahrzeugen.

Die Erfindung hat sich die Aufgabe gestellt, eine Speicheranordnung vorzuschlagen, welche sowohl bei einem Schreibzugriff einer Speicher-zugreifenden-Einheit, als auch bei einem Lesezugriff einer anderen Speicher-zugreifenden-Einheit das konsistente und insbesondere konfliktfreie Schreiben bzw. Lesen von Datenpaketen auf bzw. von wenigstens einem mit diesen beiden Speicher-zugreifenden-Einheiten verbundenen Speicherbereich ermöglicht.

Diese Aufgabe wird erfindungsgemäß gelöst durch die elektronische Speicheranordnung gemäß Anspruch 1.

Die mindestens drei Speicherbereiche sind bevorzugt Teil einer gemeinsamen physikalischen Speichereinheit oder alternativ vorzugsweise jeweils in einer eigenen physikalischen Speichereinheit angeordnet.

Die Speicherkontrolleinheit ist vorzugsweise so ausgelegt, dass nach dem Schreiben eines Datenpakets in einen der drei Speicherbereiche, das darauf folgende zu schreibende Datenpaket in einen der anderen Speicherbereiche geschrieben wird.

Die zumindest zwei Speicher-zugreifenden Einheiten sind vorzugsweise als separate elektronische Einheiten ausgebildet und dabei insbesondere eine als Sensor, wenigstens umfassend ein Sensorelement und eine Auswerteschaltung, und die andere als elektronische Kontrolleinheit, besonders bevorzugt eines Kraftfahrzeugregelungssystems. Dabei ist es zweckmäßig, dass die Speicherkontrolleinheit, die wenigstens drei Speicherbereiche sowie die Multiplexereinheiten ebenfalls in dieser elektronischen Kontrolleinheit angeordnet sind.

Ein Datenpaket bzw. definiertes Datenpaket umfasst bevorzugt mehrere Datenwörter. Insbesondere umfasst ein Datenwort eine definierte Anzahl an Bits, beispielsweise 8 bit oder 16 bit. Die Größe bzw. Struktur der Datenpakete und/oder Datenworte kann sich bezüglich der unterschiedlichen Speicher-zugreifenden-Einheiten unterscheiden.

Die Speicherkontrolleinheit ist vorzugsweise so ausgelegt, dass aufeinanderfolgende zu schreibende Datenpakete abwechselnd in zwei der drei Speicherbereiche geschrieben werden, solange kein Lesezugriff auf einen dieser beiden Speicherbereiche erfolgt.

Es ist bevorzugt, dass die Speicheranordnung als Datenpuffer ausgebildet ist, der es ermöglicht, einer der Speicher-zugreifenden-Einheiten jederzeit per Lesezugriff ein Datenpaket zur Verfügung zu stellen, wobei die andere Speicher-zugreifende-Einheit Datenpakete nacheinander jeweils in einen der Speicherbereiche schreiben kann, wobei die jeweilige Selektion des Speicherbereichs, auf den ein Schreibzugriff stattfindet, durch die Speicherkontrolleinheit durchgeführt wird.

Die Speicheranordnung ist vorzugsweise als Datenübertragungskanal zwischen den zumindest zwei Speicher-zugreifenden-Einheiten ausgebildet, wobei der Datenübertragungskanal die wenigstens drei Speicherbereiche und die Speicherzugriffe, welche durch die Speicherkontrolleinheit gesteuert werden, umfasst.

Es ist bevorzugt, dass die wenigstens drei Speicherbereiche eingangsseitig und/oder ausgangsseitig über eine, insbesondere jeweils eine, Multiplexereinheit angeschlossen sind, welche von der Speicherkontrolleinheit gesteuert wird/werden zur Zuweisung eines Lese-/ oder Schreibzugriffs der Speicher-zugreifenden-Einheiten auf einen der drei Speicherbereiche.

Vorzugsweise ist die Speicheranordnung eingangsseitig an die elektronische Auswerteschaltung eines Sensorelements als zumindest schreibende Speicher-zugreifende-Einheit angeschlossen, wobei die elektronische Auswerteschaltung des Sensorelements nacheinander immer neue Datenpakete bereitstellt und in die Speicheranordnung schreibt.

Es ist zweckmäßig, dass die Speicherkontrolleinheit so ausgebildet ist, dass sie nach außen, also gegenüber den Speicher-zugreifenden-Einheiten, nur einmal einen definierten Adressbereich abbildet, wobei die Speicher-zugreifenden-Einheiten und insbesondere andere externe Einheiten, diesen Adressbereich nur einmal und nicht dessen dreifache Verwirklichung in den drei Speicherbereichen adressieren. Dabei ist der extern sichtbare bzw. adressierbare Adressbereich besonders bevorzugt so groß, wie der interne Adressbereich jedes der zumindest drei Speicherbereiche einzeln.

Es ist bevorzugt, dass die Speicherkontrolleinheit so ausgebildet ist, dass beim Vorliegen eines Datenanforderungssignals der Lesezugriff auf den zuletzt beschriebenen Speicherbereich durchgeführt wird, wobei das zuletzt durchgeführte Schreiben eines Datenpakets abgeschlossen worden sein muss.

Es ist zweckmäßig, dass die Speicheranordnung gemäß eines auswählend-lesenden Modus "Sample Mode" ausgebildet ist, wobei nach dem Übertragen eines Daten-Einfrieren-Signals von einer lesenden Speicher-zugreifenden-Einheit an die Speicherkontrolleinheit Daten in einem der Speicherbereiche in unveränderter Form für eine definierte Zeit, beispielsweise bis sie tatsächlich ausgelesen werden, konserviert werden, woraufhin der weitere Schreibezugriff auf den zuletzt beschriebenen Speicherbereich so lange durch die Speicherkontrolleinheit verwehrt und/oder gesperrt wird, bis zu einem späteren Zeitpunkt die gewünschten Daten aus diesem Speicherbereich ausgelesen worden sind oder bis ein neues Daten-Einfrieren-Signal von der lesenden Speicher-zugreifenden-Einheit geschickt wird, wobei dieser Schreibzugriff abgeschlossen sein muss.

Es ist bevorzugt, dass die Speicheranordnung zusätzlich eine Kontrollleseeinheit aufweist, welche mit jedem der drei Speicherbereiche, insbesondere mittels eines Multiplexers, und der Speicherkontrolleinheit verbunden ist und wobei die Kontrollleseeinheit so ausgelegt ist und so angesteuert wird, dass jeweils nach einem Schreibevorgang das zuletzt geschriebene Datenpaket direkt wieder ausgelesen wird und anschließend mit dem zuletzt zu schreibenden Datenpaket wieder verglichen wird, um einen oder mehrere mögliche Schreibefehler zu erkennen, wobei erst nach dem Wiederauslesen und erfolgreichen Vergleich durch die Kontrollleseeinheit der komplette Schreibzugriff beendet ist. Insbesondere ist die Speicheranordnung so ausgebildet, dass nach einem nicht erfolgreichen Vergleich, also die verglichenen Datenpakete unterscheiden sich, der Schreibvorgang wiederholt wird und/oder ein Schreibfehler elektronisch signalisiert bzw. vermerkt wird.

Vorzugsweise ist das Datenanforderungssignal und / oder das Daten-Einfrieren-Signal ersetzt durch einen Lesezugriff auf eine definierte Speicheradresse.

Es ist bevorzugt, dass die schreibende Speicher-zugreifende-Einheit ein Signal mit der Information, dass im Rahmen eines Schreibzugriffs ein Datenpaket zu Ende geschrieben wurde, an die Speicherkontrolleinheit bereitstellt.

Es ist zweckmäßig, dass die lesende Speicher-zugreifende-Einheit ein Signal mit der Information, dass im Rahmen eines Lesezugriffs ein Datenpaket zu Ende gelesen wurde, an die Speicherkontrolleinheit bereitstellt.

Die Erfindung bezieht sich außerdem auf die Verwendung der Speicheranordnung in Kraftfahrzeugen, insbesondere in einer elektronischen Kontrolleinheit eines Kraftfahrzeugregelungssystems.

Bevorzugt sind die drei Speicherbereiche im Wesentlichen gleich ausgebildet und weisen jeweils den identischen Speicherumfang bzw. Adressumfang auf.

Unter einer Multiplexereinheit wird vorzugsweise ein Multiplexer oder ein Demultiplexer verstanden.

Ausgangsseitig ist die Speicheranordnung bevorzugt direkt oder indirekt mit einer als elektronische Kontrolleinheit ausgebildeten Speicher-zugreifenden-Einheit verbunden, welche nacheinander bestimmte Datenpakete aus der Speicheranordnung ausliest.

Die Speicheranordnung umfasst insbesondere mehr als drei Speicherbereiche, beispielsweise redundante Speicherbereiche, um die Ausfallsicherheit zu erhöhen.

Zweckmäßigerweise wird die Information, dass im Rahmen eines Schreibzugriffs oder Lesezugriffs Daten bzw. Datenpakete zu Ende geschrieben oder gelesen wurden bzw. dass der Schreibzugriff beendet ist, dadurch mitgeteilt, dass diese Information auf/in eine definierte Adresse geschrieben wird.

Es zeigen in schematischer Darstellung
Fig. 1 ein Ausführungsbeispiel einer dreistufigen Speicheranordnung sowie
Fig. 2 die Lese- und Schreibezugriffsmöglichkeiten, gleichzeitig für zwei Speicherbereiche, anhand einer Matrixdarstellung beispielhaft veranschaulicht.

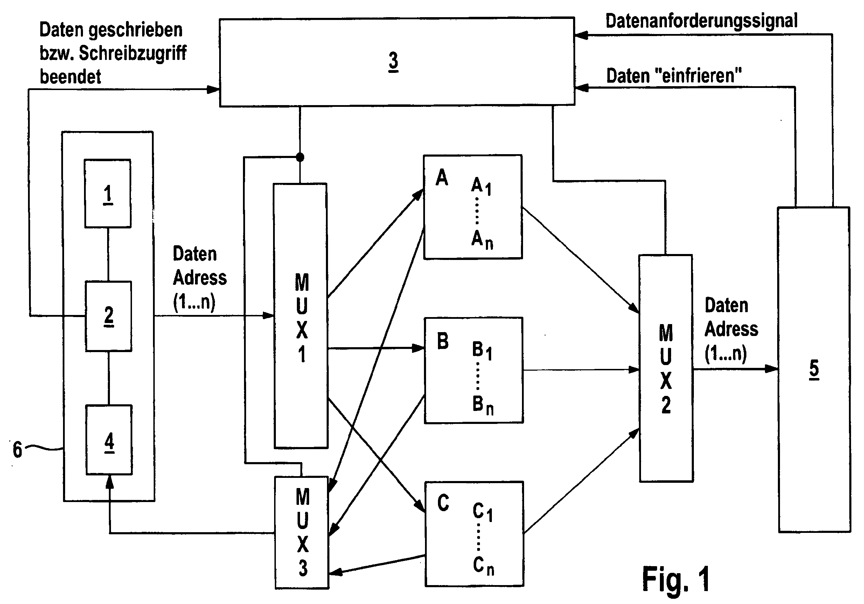

Bei der in Fig. 1 gezeigten Speicheranordnung werden die durch Sensorelement 1 bereitgestellten Messsignale durch elektronische Auswerteschaltung 2 verarbeitet. Auswerteschaltung 2 stellt nacheinander Datenpakete bzw. verschiedene Daten, wie beispielsweise immer neu erfasste Messdaten sowie Fehlerdaten, bereit, welche an bestimmten Adressen gespeichert werden sollen. Die Speicheranordnung umfasst dafür drei Speicherbereiche A, B und C eines gemeinsamen physikalischen Speichers mit jeweils dem gleichen Adressumfang A1 bis An, B1 bis Bn, sowie C1 bis Cn. Die Schreibezugriffe und Lesezugriffe auf diese Speicherbereiche werden durch Speicherkontrolleinheit 3 definiert bzw. bestimmt. Wenn neue Daten durch Auswerteschaltung 2 geschrieben werden sollen bzw. ein entsprechender Schreibzugriff erfolgen soll, wird Multiplexer MUX1, an dem diese Daten dann eingangsseitig anliegen, so von der Speicherkontrolleinheit 3 angesteuert, dass die neuen Daten bzw. ein neues Datenpaket in einen der Speicherbereiche A bis C geschrieben werden, in den gewünschten Adressbereich. Eingangsseitig ist die Speicheranordnung mit einer vornehmlich schreibenden Speicher-zugreifenden-Einheit 6 verbunden, welche beispielgemäß das Sensorelement 1, die elektronische Auswerteschaltung 2 sowie eine Kontrollleseeinheit 4 umfasst, und ausgangsseitig mit einer vornehmlich lesenden Speicher-zugreifenden-Einheit 5, welche beispielsweise als eine elektronische Kontrolleinheit ausgebildet sein kann, die auf Sensordaten zugreift.

Bei dem Signal "Daten geschrieben" bzw. "Schreibzugriff erfolgt" teilt die Auswerteschaltung 2 der Speicherkontrolleinheit zum Ende eines entsprechenden Schreibzugriffs mit, bei welchem neue Daten bzw. ein neues Datenpaket nachkommt, dass dieser Schreibzugriff beendet ist und der entsprechende Speicherbereich für einen Lesezugriff oder einen erneuten Schreibzugriff freigegeben werden kann.

Das neue Datenpaket wird dabei beispielsweise in den ersten Speicherbereich A geschrieben, während beispielsweise ein Lesezugriff auf Speicherbereich C stattfindet. Wenn dieser Schreibvorgang beendet ist, wird das nachfolgende neue Datenpaket in den vorgesehenen Adressbereich des zweiten Speicherbereichs B geschrieben. Solange der Lesezugriff auf Speicherbereich C nicht beendet ist, erfolgt bei Anliegen der entsprechenden nächsten neuen Daten die Schreibzugriffe auf den erste und die zweiten Speicherbereich A, B abwechselnd.

Beim Vorliegen eines anschließenden Datenanforderungssignals "Daten lesen" bzw. "Daten anfordern" der Lese-Einheit 5 im "Continuous Mode" wird der nachfolgende Lesezugriff zweckmäßigerweise auf den zuletzt beschriebenen Speicherbereich, also A oder B durchgeführt, wobei dieser zuletzt durchgeführte Schreibzugriff abgeschlossen worden sein muss. Solange der Lesezugriff nicht beendet ist, wird kein weiterer Schreibzugriff auf diesen Speicherbereich von der Speicherkontrolleinheit erlaubt und die beiden übrigen Speicherbereiche, also A oder B und zusätzlich C werden mit den von nun an nachfolgenden neuen Daten bzw. Datenpaketen abwechselnd beschrieben, bis ein neuer Lesezugriff erfolgt. Das Auslesen der Daten wird ebenfalls von der Speicherkontrolleinheit 3 gesteuert und über Multiplexereinheit MUX2 durchgeführt.

Im "Sample Mode" überträgt die Lese-Einheit 5 ein Daten-Einfrieren-Signal an die Speicherkontrolleinheit 3, worauf Daten in unveränderter Form für eine definierte Zeit, beispielsweise bis sie tatsächlich ausgelesen werden, konserviert werden, und der weitere Schreibezugriff auf den zuletzt beschriebenen Speicherbereich so lange durch die Speicherkontrolleinheit verwehrt bzw. gesperrt, bis zu einem späteren Zeitpunkt die gewünschten Daten aus diesem Speicherbereich ausgelesen worden sind oder bis ein neues Daten-Einfrieren-Signal von den Lese-Einheit geschickt wird, wobei dieser Schreibzugriff abgeschlossen sein muss.

Im "Sample Mode" überträgt die Lese-Einheit 5 ein Daten-Einfrieren-Signal an die Speicherkontrolleinheit 3, worauf Daten in unveränderter Form für eine definierte Zeit, beispielsweise bis sie tatsächlich ausgelesen werden, konserviert werden, und der weitere Schreibezugriff auf den zuletzt beschriebenen Speicherbereich, wobei dieser Schreibzugriff abgeschlossen sein muss, so lange durch die Speicherkontrolleinheit verwehrt bzw. gesperrt wird, bis zu einem späteren Zeitpunkt die gewünschten Daten aus diesem Speicherbereich ausgelesen worden sind oder bis ein neues Daten-Einfrieren-Signal von den Lese-Einheit geschickt wird.

Die schreibende Speicher-zugreifende-Einheit 6 umfasst außerdem Kontrollleseeinheit 4, welche mit jeder der drei Speicherbereiche A, B und C mittels eines Multiplexers MUX3, und der Speicherkontrolleinheit 3 verbunden ist und welche so ausgelegt ist und so angesteuert wird, dass jeweils nach einem Schreibevorgang zumindest das wenigstens eine geschriebene Datenpaket direkt wieder ausgelesen wird und anschließend direkt mit dem zu schreibenden Datenpaket wieder in der Auswerteschaltung 2 verglichen wird, um einen oder mehrere mögliche Schreibefehler zu erkennen. Erst nach dem Wiederauslesen durch die Kontrollleseeinheit 4 ist der komplette Schreibzugriff beendet und Kontrolleinheit 2 sendet das entsprechende Signal, beispielweise "Daten geschrieben" an die Speicherkontrolleinheit 3.

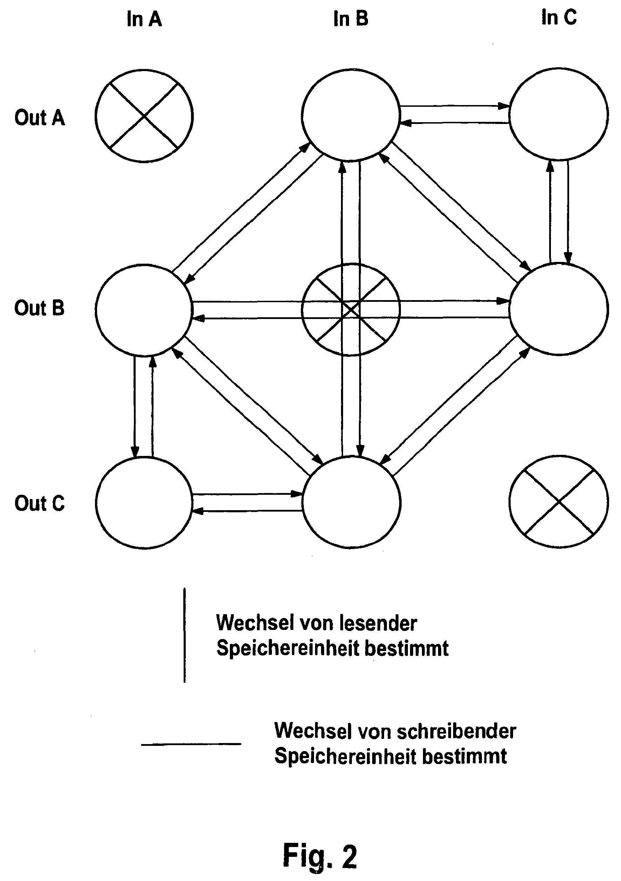

In Fig. 2 werden die Wechsel der Schreibzugriffe "In" auf die Speicherbereiche A, B und C sowie die Wechsel der Lesezugriffe "Out" auf die Speicherbereiche A, B, C veranschaulicht. Dabei ist gleichzeitiges Schreiben "In" und Lesen "Out" auf einen Speicherbereich nicht erlaubt, was durch ein X veranschaulicht ist. Die Pfeile in vertikaler Richtung kennzeichnen Übergänge bei denen nach dem Ende eines Lesezugriffs ein neuer Lesezugriff auf einen anderen Speicherbereich mit aktuelleren Daten erfolgt. Die horizontalen Pfeile kennzeichnen die Wechsel der Schreibzugriffe, jeweils nach dem Ende eines erfolgten Schreibzugriffs. Die diagonalen Pfeile kennzeichnen Übergänge bei gleichzeitigem Ende eines Schreibezugriffs und dem Ende eines Lesezugriffs.

## Patentansprüche

1. Elektronische Speicheranordnung, umfassend mindestens drei Speicherbereiche (A, B, C), eine Speicherkontrolleinheit (3) und zumindest zwei Speicher-zugreifende-Einheiten (5, 6), wobei wenigstens eine Speicher-zugreifende-Einheit (6) Schreibezugriffe ausführen kann und zumindest die andere Speicher-zugreifende-Einheit (5) Lesezugriffe ausführen kann und wobei die Speicherkontrolleinheit (3) die Zugriffe auf die mindestens drei Speicherbereiche (A, B, C) bestimmt, wobei die Speicherkontrolleinheit (3) so ausgelegt ist, dass nach dem Schreiben eines Datenpakets in einen der drei Speicherbereiche (A, B, C), das darauf folgende zu schreibende Datenpaket in einen Speicherbereich geschrieben wird, auf den während dieses folgenden Schreibzugriffs zeitgleich kein Lesezugriff stattfindet
**dadurch gekennzeichnet, dass** die Speicheranordnung gemäß eines auswählend-lesenden Modus "Sample Mode" ausgebildet ist, wobei nach dem Übertragen eines Daten-Einfrieren-Signals von einer lesenden Speicherzugreifenden-Einheit (5) an die Speicherkontrolleinheit (3) Daten in einem der Speicherbereiche (A, B, C) in unveränderter Form für eine definierte Zeit konserviert werden, woraufhin der weitere Schreibezugriff auf den zuletzt beschriebenen Speicherbereich so lange durch die Speicherkontrolleinheit verwehrt und/oder gesperrt wird, bis zu einem späteren Zeitpunkt die gewünschten Daten aus diesem Speicherbereich ausgelesen worden sind oder bis ein neues Daten-Einfrieren-Signal von der lesenden Speicher-zugreifenden-Einheit (5) geschickt wird, wobei dieser Schreibzugriff abgeschlossen sein muss.

2. Speicheranordnung nach Anspruch 1, **dadurch gekennzeichnet, dass** die Speicherkontrolleinheit (3) so ausgelegt ist, dass nach dem Schreiben eines Datenpakets in einen der drei Speicherbereiche (A), das darauf folgende zu schreibende Datenpaket in einen der anderen Speicherbereiche (B, C) geschrieben wird.

3. Speicheranordnung nach Anspruch 1 oder 2, **dadurch gekennzeichnet, dass** die Speicherkontrolleinheit (3) so ausgelegt ist, dass aufeinanderfolgende zu schreibende Datenpakete abwechselnd in zwei der drei Speicherbereiche (A, B, C) geschrieben werden, solange kein Lesezugriff auf einen dieser beiden Speicherbereiche erfolgt.

4. Speicheranordnung nach mindestens einem der Ansprüche 1 bis 3, **dadurch gekennzeichnet, dass** die Speicheranordnung als Datenpuffer ausgebildet ist, der es ermöglicht, einer der Speicher-zugreifenden-Einheiten (5) jederzeit per Lesezugriff ein Datenpaket zur Verfügung zu stellen, wobei die andere Speicher-zugreifende-Einheit (6) Datenpakete nacheinander jeweils in einen der Speicherbereiche (A, B, C) schreiben kann, wobei die jeweilige Selektion des Speicherbereichs, auf den ein Schreibzugriff stattfindet, durch die Speicherkontrolleinheit (3) durchgeführt wird.

5. Speicheranordnung nach mindestens einem der Ansprüche 1 bis 4, **dadurch gekennzeichnet, dass** die Speicheranordnung als Datenübertragungskanal zwischen den zumindest zwei Speicher-zugreifenden-Einheiten (5, 6) ausgebildet ist, wobei der Datenübertragungskanal die wenigstens drei Speicherbereiche (A, B, C) und die Speicherzugriffe, welche durch die Speicherkontrolleinheit (3) gesteuert werden, umfasst.

6. Speicheranordnung nach mindestens einem der Ansprüche 1 bis 5, **dadurch gekennzeichnet, dass** die wenigstens drei Speicherbereiche (A, B, C) eingangsseitig und/oder ausgangsseitig über eine, insbesondere jeweils eine, Multiplexereinheit (Mux1, Mux2) angeschlossen sind, welche von der Speicherkontrolleinheit (3) gesteuert wird/werden zur Zuweisung eines Lese-/ oder Schreibzugriffs der Speicher-zugreifenden-Einheiten (5, 6) auf einen der drei Speicherbereiche (A, B, C).

7. Speicheranordnung nach mindestens einem der Ansprüche 1 bis 6, **dadurch gekennzeichnet, dass** die Speicheranordnung eingangsseitig an die elektronische Auswerteschaltung (2) eines Sensorelements (1) als zumindest schreibende Speicher-zugreifende-Einheit (6) angeschlossen ist, wobei die elektronische Auswerteschaltung (2) des Sensorelements (1) nacheinander immer neue Datenpakete bereitstellt und in die Speicheranordnung schreibt.

8. Speicheranordnung nach mindestens einem der Ansprüche 1 bis 7, **dadurch gekennzeichnet, dass** die Speicherkontrolleinheit (3) so ausgebildet ist, dass sie nach außen, also gegenüber den Speicher-zugreifenden-Einheiten (5, 6), nur einmal einen definierten Adressbereich (1...n) abbildet, wobei die Speicher-zugreifenden-Einheiten (5, 6) und insbesondere andere externe Einheiten, diesen Adressbereich (1....n) nur einmal und nicht dessen dreifache Verwirklichung in den drei Speicherbereichen (A₁...Aₙ, B₁...Bₙ, C₁...Cₙ) adressieren.

9. Speicheranordnung nach mindestens einem der Ansprüche 1 bis 8, **dadurch gekennzeichnet, dass** die Speicherkontrolleinheit (3) so ausgebildet ist, dass beim Vorliegen eines Datenanforderungssignals der Lesezugriff auf den zuletzt beschriebenen Speicherbereich durchgeführt wird, wobei das zuletzt durchgeführte Schreiben eines Datenpakets abgeschlossen worden sein muss.

10. Speicheranordnung nach mindestens einem der Ansprüche 1 bis 9, **dadurch gekennzeichnet, dass** die Speicheranordnung zusätzlich eine Kontrollleseeinheit (4) aufweist, welche mit jedem der drei Speicherbereiche (A, B, C), insbesondere mittels eines Multiplexers (Mux3), und der Speicherkontrolleinheit (3) verbunden ist und wobei die Kontrollleseeinheit (4) so ausgelegt ist und so angesteuert wird, dass jeweils nach einem Schreibevorgang das zuletzt geschriebene Datenpaket direkt wieder ausgelesen wird und anschließend mit dem zuletzt zu schreibenden Datenpaket wieder verglichen wird, um einen oder mehrere mögliche Schreibefehler zu erkennen, wobei erst nach dem Wiederauslesen und erfolgreichen Vergleich durch die Kontrollleseeinheit (4) der komplette Schreibzugriff beendet ist.

11. Speicheranordnung nach mindestens einem der Ansprüche 9 bis 10, **dadurch gekennzeichnet, dass** das Datenanforderungssignal und / oder das Daten-Einfrieren-Signal ersetzt ist durch einen Lesezugriff auf eine definierte Speicheradresse.

12. Speicheranordnung nach mindestens einem der Ansprüche 1 bis 11, **dadurch gekennzeichnet, dass** die schreibende Speicher-zugreifende-Einheit (6) ein Signal mit der Information, dass im Rahmen eines Schreibzugriffs ein Datenpaket zu Ende geschrieben wurde, an die Speicherkontrolleinheit (3) bereitstellt.

13. Speicheranordnung nach mindestens einem der Ansprüche 1 bis 12, **dadurch gekennzeichnet, dass** die lesende Speicher-zugreifende-Einheit (5) ein Signal mit der Information, dass im Rahmen eines Lesezugriffs ein Datenpaket zu Ende gelesen wurde, an die Speicherkontrolleinheit (3) bereitstellt.

14. Verwendung der Speicheranordnung nach mindestens einem der Ansprüche 1 bis 13 in Kraftfahrzeugen, insbesondere in einer elektronischen Kontrolleinheit eines Kraftfahrzeugregelungssystems.

## Claims

1. Electronic memory arrangement comprising at least three memory areas (A, B, C), a memory control unit (3) and at least two memory-accessing units (5, 6), wherein at least one memory-accessing unit (6) can carry out write accesses and at least the other memory-accessing unit (5) can carry out read accesses and wherein the memory control unit (3) determines the accesses to the at least three memory areas (A, B, C), wherein the memory control unit (3) is designed in such a manner that after the writing of a data packet to one of the three memory areas (A, B, C), the following data packet to be written is written to a memory area to which no read access takes place simultaneously during this subsequent write access,
**characterized in that** the memory arrangement is constructed in accordance with a selecting-reading "sample mode", wherein after the transmission of a data freeze signal by a reading memory-accessing unit (5) to the memory control unit (3), data are preserved in one of the memory areas (A, B, C) in unchanged form for a defined period, whereupon the further write access to the memory area last written to is prevented and/or blocked by the memory control unit until the desired data have been read out of this memory area at a later time or until a new data freeze signal is sent by the reading memory-accessing unit (5), wherein this write access must be concluded.

2. Memory arrangement according to Claim 1, **characterized in that** the memory control unit (3) is designed in such a manner that after the writing of a data packet to one of the three memory areas (A), the subsequent data packet to be written is written to one of the other memory areas (B, C).

3. Memory arrangement according to Claim 1 or 2, **characterized in that** the memory control unit (3) is designed in such a manner that successive data packets to be written are written alternately to two of the three memory areas (A, B, C) as long as there is no read access to one of these two memory areas.

4. Memory arrangement according to at least one of Claims 1 to 3, **characterized in that** the memory arrangement is constructed as a data buffer which enables one of the memory-accessing units (5) to be provided with a data packet at any time per read access, wherein the other memory-accessing unit (6) can write data packets successively in each case to one of the memory areas (A, B, C), wherein the respective selection of the memory area to which a write access is taking place is performed by the memory control unit (3).

5. Memory arrangement according to at least one of Claims 1 to 4, **characterized in that** the memory arrangement is constructed as data transmission channel between the at least two memory-accessing units (5, 6), wherein the data transmission channel comprises the at least three memory areas (A, B, C) and the memory accesses which are controlled by the memory control unit (3).

6. Memory arrangement according to at least one of Claims 1 to 5, **characterized in that** the at least three memory areas (A, B, C) are connected at the input end and/or the output end via a, especially in each case one, multiplexer unit (Mux1, Mux2) which is/are controlled by the memory control unit (3) for assigning a read or write access of the memory-accessing units (5, 6) to one of the three memory areas (A, B, C).

7. Memory arrangement according to at least one of Claims 1 to 6, **characterized in that** the memory arrangement is connected at the input end to the electronic evaluating circuit (2) of a sensor element (1) as at least writing memory-accessing unit (6), wherein the electronic evaluating circuit (2) of the sensor element (1) successively continuously provides, and writes into the memory arrangement, new data packets.

8. Memory arrangement according to at least one of Claims 1 to 7, **characterized in that** the memory control unit (3) is constructed in such a manner that it displays a defined address area (1...n) only once towards the outside, that is to say with respect to the memory-accessing units (5, 6), wherein the memory-accessing units (5, 6) and especially other external units address this address area (1..n) only once and not its triple realization in the three memory areas (A₁,...Aₙ, B₁, ...Bₙ, C₁, ...Cₙ).

9. Memory arrangement according to at least one of Claims 1 to 8, **characterized in that** the memory control unit (3) is constructed in such a manner that in the case of the presence of a data request signal, the read access is carried out to the last memory area written to, wherein the writing of a data packet performed last must have been concluded.

10. Memory arrangement according to at least one of Claims 1 to 9, **characterized in that** the memory arrangement additionally has a control read unit (4) which is connected to each of the three memory areas (A, B, C), especially by means of a multiplexer (Mux 3), and the memory control unit (3) and wherein the control read unit (4) is designed in such a manner and activated in such a manner that in each case after a write process, the data packet written last is directly read out again and subsequently compared again with the data packet to be written lastly in order to detect one or more possible write errors, wherein the complete write access is ended only after the repeated reading-out and successful comparison by the control read unit (4).

11. Memory arrangement according to at least one of Claims 9 to 10, **characterized in that** the data request signal and/or the data freeze signal is replaced by a read access to a defined memory address.

12. Memory arrangement according to at least one of Claims 1 to 11, **characterized in that** the writing memory-accessing unit (6) provides a signal with the information that a data packet has been written completely, as part of a write access, to the memory control unit (3).

13. Memory arrangement according to at least one of Claims 1 to 12, **characterized in that** the reading memory-accessing unit (5) provides a signal with the information that a data packet has been read completely, as part of a read access, to the memory control unit.

14. Use of the memory arrangement according to at least one of Claims 1 to 13 in motor vehicles, especially in an electronic control unit of a motor vehicle control system.

## Revendications

1. Système de mémoire électronique, comprenant au moins trois zones de mémoire (A, B, C), un contrôleur de mémoire (3), et au moins deux unités d'accès à la mémoire (5, 6), dans lequel au moins une unité d'accès à la mémoire (6) peut effectuer des accès en écriture et au moins l'autre unité d'accès à la mémoire (5) peut effectuer des accès en lecture et dans lequel le contrôleur de mémoire (3) détermine les accès aux au moins trois zones de mémoire (A, B, C), dans lequel le contrôleur de mémoire (3) est conçu de manière à ce que, après l'écriture d'un paquet de données dans l'une des trois zones de mémoire (A, B, C), le paquet devant ensuite être écrit est écrit dans une zone de mémoire dans laquelle il ne se produit aucun accès en lecture simultané pendant ledit accès en écriture suivant,
**caractérisé en ce que** le système de mémoire est réalisé conformément à un mode de lecture à échantillonnage "sample mode", dans lequel, après la transmission d'un signal de maintien des données par une unité d'accès à la mémoire (5) effectuant une lecture au contrôleur de mémoire (3), des données sont conservées sous forme non modifiée pendant un temps défini dans l'une des zones de mémoire (A, B, C), à la suite de quoi l'accès en écriture suivant à la zone de mémoire écrite en dernier est empêché et/ou bloqué par le contrôleur de mémoire jusqu'à ce que, à un instant ultérieur, les données souhaitées aient été lues depuis ladite zone de mémoire ou jusqu'à ce qu'un nouveau signal de maintien des données ait été envoyé par l'unité d'accès à la mémoire (5) effectuant la lecture, dans lequel ledit accès en écriture doit être achevé.

2. Système de mémoire selon la revendication 1, **caractérisé en ce que** le contrôleur de mémoire (3) est conçu de manière à ce que, après l'écriture d'un paquet de données dans l'une des trois zones de mémoire (A), le paquet de données devant être écrit suivant est écrit dans l'une des autres zones de mémoire (B, C).

3. Système de mémoire selon la revendication 1 ou 2, **caractérisé en ce que** le contrôleur de mémoire (3) est conçu de manière à ce que des paquets de données devant être écrits consécutivement sont écrits de manière alternée dans deux des trois zones de mémoire (A, B, C) tant qu'aucun accès en lecture n'est effectué à l'une desdites deux zones de mémoire.

4. Système de mémoire selon au moins l'une des revendications 1 à 3, **caractérisé en ce que** le système de mémoire est réalisé sous la forme d'un tampon de données qui permet à l'une des unités d'accès à la mémoire (5) de délivrer à chaque accès en lecture un paquet de données, dans lequel l'autre unité d'accès à la mémoire (6) peut respectivement écrire des paquets de données consécutifs dans l'une des zones de mémoire (A, B, C), dans lequel la sélection respective de la zone de mémoire à laquelle un accès en écriture se produit, s'effectue par l'intermédiaire du contrôleur de mémoire (3).

5. Système de mémoire selon au moins l'une des revendications 1 à 4, **caractérisé en ce que** le système de mémoire est réalisé sous la forme d'un canal de transmission de données entre les au moins deux unités d'accès à la mémoire (5, 6), dans lequel le canal de transmission de données comprend les au moins trois zones de mémoire (A, B, C) et les accès en écriture qui sont commandés par le contrôleur de mémoire (3).

6. Système de mémoire selon au moins l'une des revendications 1 à 5, **caractérisé en ce que** les au moins trois zones de mémoire (A, B, C) sont raccordées, côté entrée et/ou côté sortie, par l'intermédiaire d'une unité de multiplexage, notamment d'une unité de multiplexage respective (Mux1, Mux2), qui est/sont commandée(s) par le contrôleur de mémoire (3) pour allouer aux unités d'accès à la mémoire (5, 6) un accès en lecture/ou en écriture à l'une des trois zones de mémoire (A, B, C).

7. Système de mémoire selon au moins l'une des revendications 1 à 6, **caractérisé en ce que** le système de mémoire est raccordé, côté entrée, au circuit d'évaluation électronique (2) d'un élément détecteur (1) au moins en tant qu'unité d'accès à la mémoire (6) effectuant une écriture, dans lequel le circuit d'évaluations électronique (2) de l'élément détecteur (1) fournit toujours de nouveaux paquets de données consécutifs et les écrit dans le système de mémoire.

8. Système de mémoire selon au moins l'une des revendications 1 à 7, **caractérisé en ce que** le contrôleur de mémoire (3) est conçu de manière à ne présenter qu'une seule fois extérieurement et par conséquent par rapport aux unités d'accès à la mémoire (5, 6), une zone d'adresse (1...n) définie, dans lequel les unités d'accès à la mémoire (5, 6), notamment d'autres unités externes, n'adressent ladite zone de mémoire (1...n) qu'une seule fois et ne réalisent pas cet adressage trois fois dans les trois zones de mémoire (A₁...Aₙ, B₁...Bₙ, C₁...Cₙ).

9. Système de mémoire selon au moins l'une des revendications 1 à 8, **caractérisé en ce que** le contrôleur de mémoire (3) est conçu de manière à ce que, en présence d'un signal de demande de données, l'accès en lecture soit effectué dans la zone de mémoire écrite en dernier, dans lequel l'écriture effectuée en dernier d'un paquet de données doit être achevée.

10. Système de mémoire selon au moins l'une des revendications 1 à 9, **caractérisé en ce que** le système de mémoire comprend en outre une unité de lecture de contrôle (4) qui est connectée à chacune des trois zones de mémoire (A, B, C), notamment au moyen d'un multiplexeur (Mux3), et au contrôleur de mémoire (3) et dans lequel l'unité de lecture de contrôle (4) est conçue et est commandée de manière à ce que, après un processus d'écriture, le paquet de données écrit en dernier soit respectivement de nouveau lu puis comparé au paquet de données écrit en dernier afin de détecter une ou plusieurs erreurs d'écriture possibles, dans lequel l'accès en écriture complet n'est terminé qu'après la relecture et la comparaison positive effectuée par l'unité de lecture de contrôle (4).

11. Système de mémoire selon au moins l'une des revendications 9 à 10, **caractérisé en ce que** le signal de demande de données et/ou le signal de maintien de données est remplacé par un accès en lecture à une adresse de mémoire définie.

12. Système de mémoire selon au moins l'une des revendications 1 à 11, **caractérisé en ce que** l'unité d'accès à la mémoire (6) effectuant une écriture fournit au contrôleur de mémoire (3) un signal contenant les informations indiquant qu'un paquet de données a été écrit jusqu'à la fin dans le contexte d'un accès en écriture.

13. Système de mémoire selon au moins l'une des revendications 1 à 12, **caractérisé en ce que** l'unité d'accès à la mémoire (5) effectuant une lecture fournit au contrôleur de mémoire (3) un signal contenant les informations indiquant qu'un paquet de données a été lu jusqu'à la fin dans le contexte d'un accès en lecture.

14. Utilisation du système de mémoire selon au moins l'une des revendications 1 à 13 dans des véhicules automobiles, notamment dans une unité de contrôle électronique d'un système de commande de véhicule automobile.
